(19) Europäisches Patentamt
European Patent Office
Office européen des brevets

(11) **EP 4 560 336 B1**

(12) **EUROPEAN PATENT SPECIFICATION**

(45) Date of publication and mention
of the grant of the patent:
**22.04.2026 Bulletin 2026/17**

(21) Application number: **24213355.1**

(22) Date of filing: **15.11.2024**

(51) International Patent Classification (IPC):
*G01R 31/392* (2019.01)

(52) Cooperative Patent Classification (CPC):
**G01R 31/392; Y02E 60/10**

(54) **ABNORMALLY DETERIORATED CELL DETECTION APPARATUS AND METHOD**

VORRICHTUNG UND VERFAHREN ZUM NACHWEIS VON ABNORMAL VERSCHLECHTERTEN ZELLEN

APPAREIL ET PROCÉDÉ DE DÉTECTION DE CELLULES ANORMALEMENT ALTÉRÉES

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **21.11.2023 KR 20230162507**

(43) Date of publication of application:
**28.05.2025 Bulletin 2025/22**

(73) Proprietor: **SAMSUNG SDI CO., LTD.**
**Yongin-si, Gyeonggi-do 17084 (KR)**

(72) Inventor: **NAM, Kyunghoon**
**17084 Yongin-si (KR)**

(74) Representative: **Marks & Clerk LLP**
**15 Fetter Lane**
**London EC4A 1BW (GB)**

(56) References cited:
**CN-A- 116 068 403      US-A1- 2021 184 278**

## Description

### FIELD

The present disclosure relates to an abnormally deteriorated cell detection apparatus and method that detect an abnormally deteriorated cell.

### BACKGROUND

Secondary batteries are batteries that may be charged and discharged, unlike primary batteries that may not be recharged. Low-capacity secondary batteries are used in portable small electronic devices such as smartphones, feature phones, laptop computers, digital cameras, and camcorders, and large-capacity secondary batteries are widely used as motor driving power and power storage batteries such as hybrid vehicles and electric vehicles. The secondary battery includes an electrode assembly including a positive electrode and a negative electrode, a case accommodating the electrode assembly, and an electrode terminal connected to the electrode assembly.

A cell in which an event such as an internal foreign material, an internal short circuit, or deterioration occurs in the secondary battery may cause safety problems such as thermal runaway or ignition, and the abnormal cell may cause a fire in the secondary battery. Therefore, early detection of abnormal cells in secondary batteries is a very important issue. US 2021/184278 A1 discloses monitoring a full charge capacity of a secondary battery including a plurality of cells.

### SUMMARY

The present disclosure attempts to provides an abnormally deteriorated cell detection apparatus and method that detect an abnormally deteriorated cell at an early stage.

However, the technical problem to be solved by the present disclosure is not limited to the above, and other objects not mentioned herein will be understood from the following description by those skilled in the art.

Embodiments of the present disclosure provide an abnormally deteriorated cell detection method that detects an abnormally deteriorated cell of a battery module including a plurality of cells, including obtaining a first statistical value representing a capacity deviation at a first time point for the plurality of cells, obtaining a second statistical value representing a capacity deviation at a second time point for the plurality of cells, comparing the first statistical value and the second statistical value to detect an abnormally deteriorated cell.

The obtaining of the first statistical value may include obtaining the first statistical value using an initial capacity value of each of the plurality of cells, and the initial capacity value may correspond to a formation capacity of each cell.

The obtaining of the first statistical value using the initial capacity value may include obtaining an average value and a standard deviation of the initial capacity values for the plurality of cells, calculating a first sigma using the initial capacity value, the average value, and the standard deviation, for each of the plurality of cells, and obtaining the first sigma calculated for each of the plurality of cells as the first statistical value.

The obtaining of the first statistical value may include detecting a first state of charge (SOC) change amount during a first period for each of the plurality of cells, obtaining an average value and a standard deviation of the first SOC change amount for the plurality of cells, calculating a second sigma using the first SOC change amount, the average value, and the standard deviation, for each of the plurality of cells, and determining the second sigma calculated for each of the plurality of cells as the first statistical value.

The detecting of the first SOC change amount may include detecting a first SOC value of each of the plurality of cells in a first idle period of the battery module, detecting a second SOC value of each of the plurality of cells in a second idle period after the first idle period of the battery module, and calculating the first SOC change amount from a difference value between the first SOC value and the second SOC value, for each of the plurality of cells.

The detecting of the first SOC value may include obtaining a first cell voltage value detected at a predetermined time elapsed from a starting time point of the first idle period, for each of the plurality of cells, and determining the first SOC value using the first cell voltage value for each of the plurality of cells.

The detecting of the second SOC value may include obtaining a second cell voltage value detected at a predetermined time elapsed from a starting time point of the second idle period, for each of the plurality of cells, and determining the second SOC value using the second cell voltage value for each of the plurality of cells.

The obtaining of the second statistical value may include detecting a second SOC change amount during a second period for each of the plurality of cells, obtaining an average value and a standard deviation of the second SOC change amount for the plurality of cells, calculating a third sigma using the SOC change amount, the average value, and the standard deviation, for each of the plurality of cells, and determining the third sigma calculated for each of the plurality of cells as the second statistical value.

The detecting of the second SOC change amount may include detecting a third SOC value of each of the plurality of cells in a third idle period of the battery module, detecting a fourth SOC value of each of the plurality of cells in a fourth idle period after the third idle period of the battery module, and calculating the second SOC change amount from a difference value between the third SOC value and the fourth SOC value, for each of the plurality of cells.

The detecting of the third SOC value may include obtaining a third cell voltage value detected at a predetermined time elapsed from a starting time point of the third idle period, for each of the plurality of cells, and determining the third SOC value using the third cell voltage value for each of the plurality of cells.

The detecting of the fourth SOC value may include obtaining a fourth cell voltage value detected at a predetermined time elapsed from a starting time point of the fourth idle period, for each of the plurality of cells, and determining the fourth SOC value using the fourth cell voltage value for each of the plurality of cells.

The detecting of the second SOC change amount may include detecting a fourth SOC change amount between an idle period after charging and an idle period after discharging for each charging/discharging cycle, for each of the plurality of cells, and determining the second SOC change amount from an average value of the fourth SOC change amount detected during the second period. The second period may include at least one charging/discharging cycle.

The detecting of the abnormally deteriorated cell may include comparing a difference value between the first statistical value and the second statistical value with a threshold value, and determining a cell whose difference value is greater than or equal to the threshold value as an abnormally deteriorated cell.

The detecting of the abnormally deteriorated cell may include calculating a difference value between the first statistical value and the second statistical value for each of the plurality of cells, using a Grubbs' test method to detect an outlier among the difference values for each of the plurality of cells, and determining a cell whose difference value is an outlier among the plurality of cells as an abnormally deteriorated cell.

Other embodiments provide an abnormally deteriorated cell detection apparatus that detects an abnormally deteriorated cell of a battery module including a plurality of cells, including: a control device configured to obtain a first statistical value representing a capacity deviation at a first time point for the plurality of cells, obtain a second statistical value representing a capacity deviation at a second time point for the plurality of cells, and detect an abnormally deteriorated cell by comparing the first statistical value and the second statistical value with each other..

The abnormally deteriorated cell detection apparatus may further include a storage device that stores an initial capacity value of the plurality of cells. The control device may be further configured to calculate a first sigma of each of the plurality of cells using the initial capacity value of each of the plurality of cells and an average value and a standard deviation of the initial capacity values of the plurality of cells, and may be further configured to use the first sigma calculated for each of the plurality of cells as the first statistical value. The initial capacity value may correspond to a formation capacity of each cell.

The control device may be further configured to detect a first SOC change amount during a first period for the plurality of cells, and calculate an average value and a standard deviation of the first SOC change amount for the plurality of cells. The control device may be further configured to calculate a second sigma of each of the plurality of cells using the first SOC change amount, the average value, and the standard deviation, and use the second sigma calculated for each of the plurality of cells as the first statistical value.

The control device may be further configured to use a first cell voltage value detected at a predetermined time elapsed from a starting time point of an idle period after first charging for each of the plurality of cells to determine a first SOC value in the idle period after the first charging. The control device may be further configured to use a second cell voltage value detected at a predetermined time elapsed from a starting time point of an idle period after first discharging for each of the plurality of cells to determine a second SOC value in the idle period after the first discharging. The control device may be further configured to determine the first SOC change amount from a difference value between the first SOC value and the second SOC value.

The control device may be further configured to detect a second SOC change amount during a second period for the plurality of cells, and calculate an average value and a standard deviation of the second SOC change amount for the plurality of cells. The control device may be further configured to calculate a third sigma of each of the plurality of cells using the second SOC change amount, the average value, and the standard deviation, and use the third sigma calculated for each of the plurality of cells as the second statistical value.

The control device may be further configured to use a third cell voltage value detected at a predetermined time elapsed from a starting time point of an idle period after second charging for each of the plurality of cells to determine a third SOC value in the idle period after the second charging. The control device may be further configured to use a fourth cell voltage value detected at a predetermined time elapsed from a starting time point of an idle period after second discharging for each of the plurality of cells to determine a fourth SOC value in the idle period after the second discharging. The control device may be further configured to determine the second SOC change amount from a difference value between the third SOC value and the fourth SOC value.

The control device may be further configured to detect, for each of the plurality of cells, a fourth SOC change amount between an idle period after charging and an idle period after discharging for each charging cycle during the second period, and determines the second SOC change amount from an average value of the fourth SOC change amount detected during the second period. The second period may include at least one charging/discharging cycle.

The control device may be further configured to compare a difference value between the first statistical value and the second statistical value with a threshold value, and determine a cell whose difference value is greater than or equal to the threshold value as an abnormally deteriorated cell.

According to the present disclosure, it is possible to prevent a safety problem from occurring due to an abnormal cell by detecting an abnormally deteriorated cell early.

However, effects obtainable through the present disclosure are not limited to the above, and other effects not mentioned herein will be clearly understood by those skilled in the art from the following disclosure.

At least some of the above and other features of the invention are set out in the claims.

## BRIEF DESCRIPTION OF THE DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 schematically illustrates an abnormally deteriorated cell detection apparatus of a battery pack according to an embodiment.
FIG. 2 is a graph representing an example of the distribution of initial capacity sigma and current capacity sigma.
FIG. 3 is a graph representing another example of the distribution of initial capacity sigma and current capacity sigma.
FIG. 4 schematically illustrates an abnormally deteriorated cell detection method according to an embodiment.
FIG. 5 illustrates an example of an energy storage system including an abnormally deteriorated cell detection apparatus according to an embodiment.

## DETAILED DESCRIPTION OF THE DRAWINGS

Hereinafter, embodiments of the present invention will be described in detail with reference to the accompanying drawings. Prior to description, it should be understood that terms and words used in the specification and the appended claims should not be construed as having common and dictionary meanings, but should be interpreted as having meanings and concepts corresponding to technical ideas of the present disclosure in view of the principle that the inventor can properly define the concepts of the terms and words in order to describe his/her own invention as best as possible. Accordingly, since the embodiment described in the specification and the configurations shown in the drawings are merely the most preferable embodiment and configurations of the present invention, they do not represent all of the technical ideas of the present invention, and it should be understood that that various equivalents and modified examples, which may replace the embodiments, are possible when filing the present application. It will be further understood that the terms "comprise, include," "comprising," and/or "including," when used in this specification, specify the presence of the stated features, integers, steps, operations, elements, and/or components but do not preclude the presence or addition of one or more other features, integers, steps, operations, elements, components, and/or groups thereof. The use of "can/may" in describing an embodiment of the present disclosure may include "one or more embodiments of the present disclosure."

In addition, in order to help understanding of the present disclosure, the accompanying drawings are not drawn to scale, and the dimensions of some components may be exaggerated. In addition, the same reference numerals may be assigned to the same elements in different embodiments.

When it is explained that two objects are 'identical', this means that these objects are 'substantially identical'. Accordingly, the substantially identical objects may include deviations considered low in the art, for example, deviations within 5 %. In addition, when it is explained that certain parameters are uniform in a predetermined region, this may mean that the parameters are uniform in terms of an average in the corresponding region.

Although the terms "first", "second", and the like are used to describe various elements, these elements are not limited by these terms. These terms are used to distinguish one element from another, and unless stated to the contrary, a first element may be a second element.

Throughout the specification, unless stated otherwise, each element may be singular or plural.

When an element is "above (or under)" or "on (or below)" another element, the element can be on an upper surface (or a lower surface) of the other element, and intervening elements may be present between the element and the other element on (or below) the element.

In addition, when an element is referred to as being "connected", "coupled" or "linked" to another element, the element can be directly connected or coupled to the other element, but it should be understood that intervening elements may be present between each element, or each element may be "connected", "coupled" or "linked" to each other through another element. When one element is referred to as being coupled (e.g., electrically coupled or connected) to another element, the one element may be directly coupled to the another element or indirectly coupled to the another element via one or more intervening elements.

Throughout the specification, "A and/or B" refers to either A or B or both A and B unless expressly stated otherwise. In other words, the term "and/or" includes all or various combinations of a plurality of items that are related and arranged. "C to D" refers to C or greater and D or smaller unless expressly stated otherwise.

Hereinafter, an apparatus and an abnormally deteriorated cell detection method according to embodiments will be described in detail with reference to the accompanying drawings.

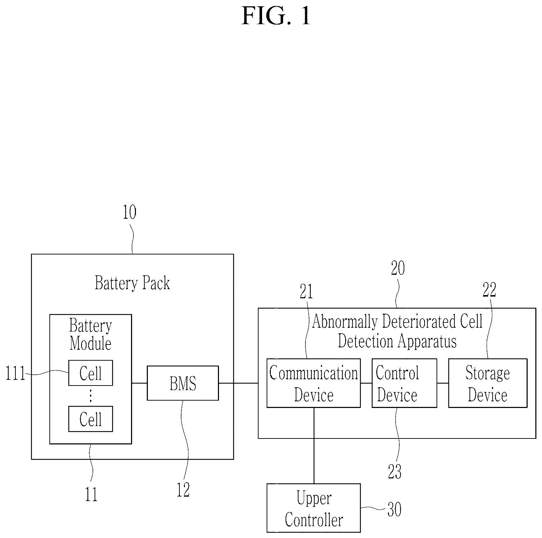

FIG. 1 schematically illustrates an abnormally deteriorated cell detection apparatus of a battery pack according to an embodiment.

Referring to FIG. 1, a battery pack 10 may include a battery module 11 including a plurality of cells 111 and a battery management system (BMS) 12 for managing the battery module 111. At least one charging/discharging cycle may be performed daily for the battery pack 10. One charging/discharging cycle may include one charging period and one discharging period. In addition, one charging/discharging cycle may additionally include an idle period after the charging period and an idle period after the discharging period. For example, one charging/discharging cycle may be configured to sequentially include a charging period, an idle period, a discharging period, and an idle period. In addition, for example, one charging/discharging cycle may be configured to sequentially include a discharging period, an idle period, a charging period, and an idle period. During each idle period, both charging and discharging of the battery pack 10 may be stopped.

The BMS 12 may detect a cell voltage of each cell 111 in each idle period of the battery pack 10. That is, the BMS 12 may detect the cell voltage of each cell 111 in the idle period following the charging period, and may detect the cell voltage of each cell 111 in the idle period following the discharging period. In order to obtain voltage data close to an open circuit voltage (OCV) of each cell 111, the BMS 12 may obtain the cell voltage value measured after a predetermined time elapses from the start time point of the idle period (that is, after a polarization voltage is removed from the cell voltage of each cell 111) as the cell voltage value of the corresponding idle period. For example, the BMS 12 may obtain the cell voltage value measured at a time point at which 20 minutes or more elapses from the start time point of the idle period as the cell voltage value of the corresponding idle period.

The BMS 12 may obtain the state of charge (SOC) value of each cell 111 using the cell voltage value detected in each idle period. In this case, the BMS 12 may calculate the SOC value of each cell using various known methods. For example, the BMS 12 may obtain the SOC value of each cell 111 using OCV-SOC data that maps the corresponding SOC for each OCV.

The BMS 12 may transmit to an abnormally deteriorated cell detection apparatus 20 during each idle period state data including at least one of the cell voltage value and the SOC value of each cell 111. When transmitting the state data, the BMS 12 may transmit identification information of the corresponding battery module 11 and the corresponding cell 111 together to be able to identify which cell 111 of which battery module 11 the corresponding state data belongs to.

The abnormally deteriorated cell detection apparatus 20 may detect the abnormally deteriorated cell by monitoring a capacity deviation between the cells 111 included in the same battery module 11. The 'capacity' of the cell 111 may refer to 'available capacity' of the cell 111. In addition, the 'abnormally deteriorated cell' may refer to a cell that has abnormally deteriorated due to abnormalities such as internal short circuit or defective electrode plate coating.

The abnormally deteriorated cell detection apparatus 20 may include a communication device 21, a storage device 22, and a control device 23.

The communication device 21 may perform a wired/wireless communication function between the abnormally deteriorated cell detection apparatus 20 and an external device of the abnormally deteriorated cell detection apparatus 20. For example, the communication device 21 may perform a wired/wireless communication function between the BMS 12 of the battery pack 10 and the abnormally deteriorated cell detection apparatus 20. In addition, for example, the communication device 21 may perform a wired/wireless communication function between an upper controller 30 and the abnormally deteriorated cell detection apparatus 20. The upper controller 30 is a controller capable of managing the operation of the abnormally deteriorated cell detection apparatus 20 outside the abnormally deteriorated cell detection apparatus 20, and may include a main controller of a system in which the battery pack 10 is installed, a manager terminal, and the like.

The storage device 22 may store state data (for example, a cell voltage value, an SOC value, and the like) of each cell 111 received from the battery pack 10. The control device 23 may monitor the state data of each cell 111 over a long period of time (for example, dozens of days) to detect abnormally deteriorated cells. Accordingly, when the state data of each cell 111 is received, the control device 23 may map the state data to the corresponding battery module 11 and the corresponding cell 111 in time series (that is, by date), and store them.

The storage device 22 may store OCV-SOC data in which the corresponding SOC is mapped for each OCV of the cell 111. The OCV-SOC data may be previously obtained using a reference cell having the same characteristics as the cell 111. For example, the OCV-SOC data may be obtained using various methods such as experiments on reference cells, charging/discharging simulation, and deep learning. The storage device 22 may store the OCV-SOC data in the form of a table.

The storage device 22 may store an initial capacity value of each cell 111 configuring the battery pack 10. The initial capacity value of each cell 111 may be a value obtained in the manufacturing step of each cell 111. For example, the initial capacity value of each cell 111 may be a formation capacity value obtained in a formation process of each cell.

The storage device 22 may store data (sigma) representing a statistical distribution (that is, initial capacity deviation) of initial capacity values of a plurality of cells 111.

Equation 1 below represents a method of calculating a statistical value (hereinafter referred to as an 'initial capacity sigma') representing an initial capacity deviation from the initial capacity value of each cell 111.

Initial Capacity Sigma (i) = - (Initial Capacity Value (i) - AVG (Initial Capacity Value (1), Initial Capacity Value (2), ..., Initial Capacity Value (N)))/STDEV (Initial Capacity Value (1), Initial Capacity Value (2), ..., Initial Capacity Value (N))    [Equation 1]

Equation 1 is for calculating the initial capacity sigma (i) for the i-th cell 111 among N cells 111 configuring the battery module 11. The initial capacity sigma (i) is a value indicating the degree to which the initial capacity value of the i-th cell 111 deviates from the average of the initial capacity values of the N cells 111 configuring the battery module 11, and using this value, the statistical distribution of the initial capacity values of the cells 111 may be confirmed. In Equation 1 above, the initial capacity value of each cell 111 obtained in the manufacturing step may be used as the initial capacity value of each cell 111 as described above. In addition, AVG (initial capacity value (1), initial capacity value (2), ..., initial capacity value (N)) and STDEV (initial capacity value (1), initial capacity value (2), ..., initial capacity value (N)) respectively represent the average value and standard deviation of the initial capacity values for all cells 111 configuring the battery module 11.

Table 1 below shows an example of an initial capacity value of each cell 111 and an initial capacity sigma of each cell 111 derived therefrom.

(Table 1)

| Cell | Cell #1 | Cell #2 | Cell #3 | Cell #4 | Cell #5 | Cell #6 | Cell #7 | Cell #8 | Cell #9 | Cell #10 |
|---|---|---|---|---|---|---|---|---|---|---|
| Initial capacity [Ah] | 92.1 | 91.2 | 92.8 | 92.2 | 91.5 | 93.5 | 92.2 | 95.6 | 93 | 90.8 |
| Initial capacity sigma | 0.3 | 0.993 | -0.238 | 0.223 | 0.762 | -0.777 | 0.223 | -2.394 | -0.392 | 1.301 |

Referring to Table 1, the smaller the initial capacity of a cell, the larger the value of initial capacity sigma may be. In Table 1 above, Cell #10 has the smallest initial capacity, and accordingly, the initial capacity sigma of Cell #10 has the largest value of 1.301. On the other hand, Cell #8 has the largest initial capacity, and accordingly, the initial capacity sigma of Cell #8 has the smallest value of -2.394. The initial capacity sigma stored in the storage device 22 may be calculated by the control device 23 to be described later. The initial capacity sigma may be calculated by an external device (for example, the upper controller 30) of the abnormally deteriorated cell detection apparatus 20 to be transmitted to the abnormally deteriorated cell detection apparatus 20.

The control device 23 may control the overall operation of the abnormally deteriorated cell detection apparatus 20.

The control device 23 may communicate with the BMS 12 or the upper controller 30 through the communication device 21. For example, the control device 23 may receive state data of each cell 111 from the BMS 12 through the communication device 21. In addition, for example, the control device 23 may receive at least one of the OCV-SOC data, the initial capacity value of each cell 111, and the statistical value (initial capacity sigma) indicating the initial capacity deviation between the cells 111 from the upper controller 30 through the communication device 21.

The control device 23 may manage data stored in the storage device 22. For example, the control device 23 may store and manage the state data of each cell 111 received from the BMS 12 in the storage device 22. In addition, for example, the control device 23 may store and manage the OCV-SOC data, the initial capacity value of each cell 111, the initial capacity sigma of each cell 111, and the like in the storage device 22.

When the initial capacity value of each cell 111 is received from the upper controller 30, the control device 23 may calculate the initial capacity value of each cell 111 and the initial capacity sigma of the cells 111 included in the battery module 11 using Equation 1 above.

When the cell voltage value detected from each cell 111 in the idle period is received from the BMS 12, the control device 23 may calculate the SOC value of each cell 111 in the idle period using the received cell voltage value and OCV-SOC data. For example, when a cell voltage value detected from each cell 111 (hereinafter referred to as a 'cell voltage value after charging') is received in the idle period after the charging period from the BMS 12, the control device 23 may obtain an SOC value (hereinafter, referred to as 'an SOC value after charging') corresponding to the cell voltage value after charging by using the OCV-SOC data. In addition, for example, when a cell voltage value detected from each cell 111 (hereinafter referred to as a 'cell voltage value after discharging') is received in the idle period after the discharging period from the BMS 12, the control device 23 may obtain an SOC value (hereinafter, referred to as 'an SOC value after discharging') corresponding to the cell voltage value after discharging by using the OCV-SOC data. The control device 23 may use the SOC value after charging calculated in this way and the SOC value after discharging to obtain a SOC change amount (the SOC value after charging - the SOC value after discharging) in the corresponding charging/discharging cycle.

Table 2 below shows an example of the SOC value after charging and the SOC value after discharging of each cell 111 derived from the cell voltage value after charging of each cell 111 and the cell voltage value after discharging using the OCV-SOC table. Table 2 also shows an example of the SOC change amount of each cell 111 derived from the SOC value after charging and the SOC value after discharging of each cell 111.

(Table 2)

| Cell | Cell #1 | Cell #2 | Cell #3 | Cell #4 | Cell #5 | Cell #6 | Cell #7 | Cell #8 | Cell #9 | Cell #10 |
|---|---|---|---|---|---|---|---|---|---|---|
| Cell voltage after charging [mV] | 3945 | 3946 | 3945 | 3945 | 3945 | 3945 | 3946 | 3960 | 3945 | 3945 |
| Cell voltage after discharging [mV] | 3408 | 3409 | 3416 | 3406 | 3398 | 3399 | 3410 | 3218 | 3413 | 3417 |
| SOC after charging [%] | 85.5 | 85.6 | 85.5 | 85.5 | 85.5 | 85.5 | 85.6 | 86.9 | 85.5 | 85.5 |
| SOC after discharging [%] | 3.4 | 3.4 | 3.7 | 3.3 | 3 | 3 | 3.4 | 0.3 | 3.5 | 3.7 |
| SOC change amount | 82.1 | 82.2 | 81.8 | 82.2 | 82.5 | 82.5 | 82.2 | 86.6 | 82 | 81.8 |

The control device 23 may receive from each cell 111 from the BMS 12 in the idle period the SOC value (the SOC value after charging and the SOC value after discharging) detected, and may obtain the SOC change amount (the SOC value after charging - the SOC value after discharging) in the corresponding charging/discharging cycle using the received SOC values. The control device 23 may continuously statistically analyze the capacity deviation of each cell 111 and detect the abnormally deteriorated cell according to the analyzed result.

The capacity of the cell 111 may decrease as deterioration progresses. Charging and discharging are performed under the same conditions for all cells 111 configuring the same battery module 11. Accordingly, the cells 111 included in the same battery module 11 should theoretically have a similar degree of deterioration and a similar capacity reduction pattern. However, the deterioration of the cell 111 in which an abnormality such as an internal short circuit occurs is accelerated compared to other cells, and as a result, the rate of capacity decrease over time may increase compared to other cells. In other words, the capacity deviation between the abnormally deteriorated cell and other cells may increase over time. Therefore, by monitoring the change in capacity deviation of the cells 111 over time, it is possible to detect a cell having a higher degree of deterioration than other cells, and furthermore, a cell in which an abnormality occurs.

The SOC change amount of the cells 111 in which charging and discharging are performed under the same condition is dependent on the capacity of each cell 111, and the smaller the capacity of the cell 111, the greater the SOC change amount per unit time. That is, the cell 111, whose capacity has decreased relatively significantly compared to other cells due to abnormally accelerated deterioration, may have a greater SOC change per unit time than other cells. Accordingly, the SOC change amount deviation of the cells 111 may show a statistical distribution similar to the capacity deviation of the cells 111.

Therefore, even if the control device 23 does not know the current capacity value of each cell 111, it may calculate a statistical value representing the current capacity deviation of the cells 111 using the SOC change amount of the cells 111. Equation 2 below represents a method of calculating a statistical value (hereinafter, referred to as a 'current capacity sigma') indicating the current capacity deviation of the cells 111 from the SOC change amount of each cell 111.

$$\text{Current capacity sigma (i)} = (\triangle SOC(i) - AVG(\triangle SOC(1), \triangle SOC(2), ..., \triangle SOC(N)))/STDEV(\triangle SOC(1), \triangle SOC(2), ..., \triangle SOC(N))$$ [Equation 2]

Equation 2 above is for calculating the current capacity sigma (i) for the i-th cell 111 among N cells 111 configuring the battery module 11. Referring to Equation 2 above, the control device 23 may calculate the current capacity sigma (i) of the i-th cell 111 by calculating the degree to which the SOC change amount ($\triangle$SOC (i) of the i-th cell 111 deviates from the average SOC change amount of the cells 111 configuring the battery module 11. The calculated current capacity sigma (i) may also be used as a value indicating the degree to which the current capacity value of the i-th cell 111 deviates from the average capacity value of the battery module 11. However, considering that the SOC change amount increases as the capacity is smaller, the minus sign ('-') of the numerator may be deleted in Equation 2, unlike Equation 1 above.

In Equation 2, as described above, the SOC change amount ($\triangle$SOC) of each cell 111 may be obtained from a difference value between the SOC value after charging and the SOC value after discharging of each cell 111. In addition, AVG($\triangle$SOC(1), $\triangle$SOC(2), ..., $\triangle$SOC(N)) and STDEV($\triangle$SOC(1), $\triangle$SOC(2), ..., $\triangle$SOC(N)) represent the average value and standard deviation of the SOC change amount ($\triangle$SOC) for all cells 111 configuring the battery module 11, respectively.

Table 3 below shows an example of the current capacity sigma of each cell 111 derived from the SOC change amount of each cell 111.

(Table 3)

| Cell | Cell #1 | Cell #2 | Cell #3 | Cell #4 | Cell #5 | Cell #6 | Cell #7 | Cell #8 | Cell #9 | Cell #10 |
|---|---|---|---|---|---|---|---|---|---|---|
| SOC change amount | 82.1 | 82.2 | 81.8 | 82.2 | 82.5 | 82.5 | 82.2 | 86.6 | 82 | 81.8 |
| Current capacity sigma | -0.361 | -0.287 | -0.582 | -0.287 | -0.066 | -0.066 | -0.287 | 2.957 | -0.435 | -0.582 |

Referring to Table 3, the larger the SOC change in a cell, the larger the current capacity sigma may be. In Table 3 above, the SOC change of Cell #8 is the largest, and accordingly, the current capacity sigma of Cell #8 has the largest value of 2.957. It may be difficult to directly compare the SOC change amount deviation of the cells 111 with the capacity deviation of the cells 111. However, when the SOC change amount deviation of the cells 111 is converted into the current capacity sigma using Equation 2 above, direct comparison with the initial capacity sigma becomes possible, as shown in Table 3 below.

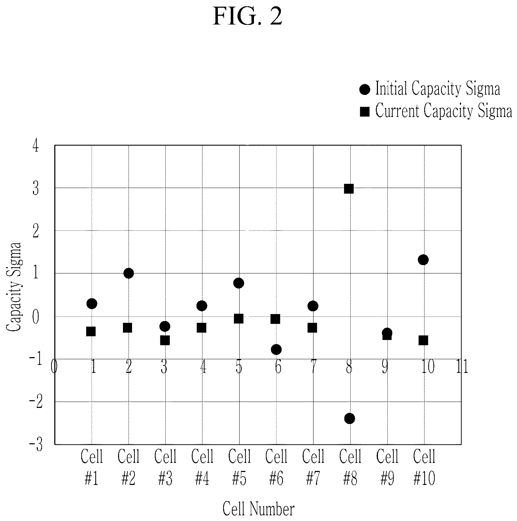

Table 4 below shows an example of the initial capacity sigma and the current capacity sigma of each cell 111. In addition, FIG. 2 illustrates a graph of the distribution of the initial and current capacity sigma of Table 4.

(Table 4)

| Cell | Cell #1 | Cell #2 | Cell #3 | Cell #4 | Cell #5 | Cell #6 | Cell #7 | Cell #8 | Cell #9 | Cell #10 |
|---|---|---|---|---|---|---|---|---|---|---|
| Initial capacity sigma | 0.3 | 0.993 | -0.238 | 0.223 | 0.762 | -0.777 | 0.223 | -2.394 | -0.392 | 1.301 |
| Current capacity sigma | -0.361 | -0.287 | -0.582 | -0.287 | -0.066 | -0.066 | -0.287 | 2.957 | -0.435 | -0.582 |
| Current capacity sigma - Initial capacity sigma | -0.661 | -1.28 | -0.344 | -0.51 | -0.828 | 0.711 | -0.51 | 5.351 | -0.043 | -1.883 |

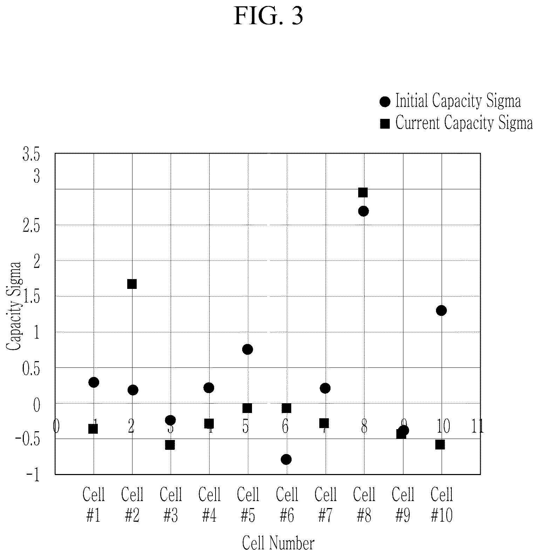

Referring to FIG. 2 and Table 4, the value of the capacity sigma may increase as the capacity is smaller. Therefore, it may be seen that a cell with an increased current capacity sigma compared to the initial capacity sigma has a relatively higher deterioration rate than other cells. On the other hand, it may be seen that a cell with a decreased current capacity sigma compared to the initial capacity sigma has a higher deterioration rate than other cells. According to this, in Table 4 above, Cell #10 has the smallest initial capacity, but the deterioration rate is rather lower than that of other cells. On the other hand, Cell #8 has the largest initial capacity, but the deterioration rate is rather higher than that of other cells. Particularly, it can be seen that Cell #8 has an abnormally increased capacity sigma compared to other cells. Table 5 below shows another example of the initial capacity sigma and the current capacity sigma of each cell 111. In addition, FIG. 3 illustrates a graph of the distribution of the initial and current capacity sigma of Table 5.

(Table 5)

| Cell | Cell #1 | Cell #2 | Cell #3 | Cell #4 | Cell #5 | Cell #6 | Cell #7 | Cell #8 | Cell #9 | Cell #10 |
|---|---|---|---|---|---|---|---|---|---|---|
| Initial capacity sigma | 0.300 | 0.2 | -0.238 | 0.223 | 0.762 | -0.777 | 0.223 | 2.7 | -0.392 | 1.301 |
| Current capacity sigma | -0.361 | 1.667 | -0.582 | -0.287 | -0.066 | -0.066 | -0.287 | 2.957 | -0.435 | -0.582 |
| Current capacity sigma - Initial capacity sigma | -0.661 | 1.467 | -0.344 | -0.51 | -0.828 | 0.711 | -0.51 | 0.257 | -0.043 | -1.883 |

Referring to Equation 1, the smaller the initial capacity of the cell, the larger the value of initial capacity sigma of the cell may be. Referring to Equation 2, the larger the SOC change of the cell, the larger the current capacity sigma may be. Furthermore, the smaller the capacity of the cell, the larger the SOC change of the cell may be during the same period of time. Accordingly, in FIG. 3 and Table 5, Cell #8 is the cell with the smallest initial capacity and current capacity. In other words, Cell #8 is in the most deteriorated state among the cells in both its initial and current states.

All cells in Table 5 were charged and discharged under the same conditions. Therefore, a cell with a much smaller initial capacity than other cells, such as Cell #8, may maintain a smaller capacity than other cells even as time passes. Meanwhile, in FIG. 3 and Table 5, Cell #2 has both initial capacity and current capacity greater than Cell #8, but is the cell with the highest capacity sigma. In other words, Cell #2 is the cell with the fastest deterioration rate among the cells, that is, the cell with the most deterioration. Referring to the above, the control device 23 may detect the cell 111 with the lowest capacity, that is, the most deteriorated cell 111, within the current battery module 11 based on the current capacity sigma. That is, the control device 23 may determine the cell 111 with the largest current capacity sigma within the battery module 11 as the most deteriorated cell.

The control device 23 may detect the cell 111 having the fastest deterioration rate within the battery module 11 based on the amount of change in the capacity sigma (current capacity sigma-initial capacity sigma). The control device 23 may determine the cell 111 with the most increased capacity sigma within the battery module 11 as the cell with the fastest deterioration rate, that is, the cell in which the deterioration has progressed the most compared to the initial state.

The control device 23 may determine an abnormally deteriorated cell based on the amount of change in capacity sigma of each cell 111 (current capacity sigma - initial capacity sigma). For example, the control device 23 may determine the cell 111 in which the change in capacity sigma is greater than or equal to a threshold value as an abnormally deteriorated cell. Here, the threshold value may be a fixed value or may vary depending on the amount of change in capacity sigma of the cells 111. In the latter case, for example, the control device 23 may determine the threshold value based on the average value, minimum value, median value, and the like of the change in capacity sigma of the cells 111 included in the battery module 11.

The control device 23 may determine the abnormally deteriorated cell using a Grubbs' test method used to detect an outlier in a data set. The control device 23 may use the Grubbs' test method to determine the outlier among the changes in capacity sigma (current capacity sigma - initial capacity sigma) of the cells 111 included in the battery module 11. When the outlier is determined, the control device 23 may determine the corresponding cell 111 as an abnormally deteriorated cell.

When the most deteriorated cell 111 within the battery module 11 is determined, the control device 23 may transmit information about this (for example, cell identification information, current capacity sigma, and the like) to the upper controller 30. When the cell 111 with the fastest deterioration rate within the battery module 11 is determined, the control device 23 may transmit information about this (for example, cell identification information, capacity sigma change amount, and the like) to the upper controller 30. When the abnormally deteriorated cell 111 within the battery module 11 is determined, the control device 23 may transmit information about this (for example, cell identification information and the like) to the upper controller 30.

The SOC value determined using OCV-SOC data and the SOC change amount calculated using it may include error components due to voltage measurement errors, environmental factors, and the like. The error components may vary depending on the state of the battery pack 10 at the time of cell voltage measurement. The control device 23 may flatten the error components in order to improve the accuracy of the SOC change amount and the current capacity sigma. That is, the control device 23 may calculate an average value of the SOC change amount of each cell 111 for several days or while a plurality of charging/discharging cycles are performed, and calculate the current capacity sigma of each cell 111 using the average value. In this case, in Equation 2 above, the SOC change amount ($\triangle$SOC) of each cell 111 may be an average value of the SOC change amount of each cell 111 detected for several days or for the plurality of charging/-

discharging cycles.

The control device 23 may perform filtering on the SOC change amount in order to improve the accuracy of the SOC change amount and the accuracy of the current capacity sigma. For example, the control device 23 may detect the current capacity sigma of each cell 111 using the SOC change amount for charging/discharging cycles in which all SOC change amounts of the cells 111 are greater than or equal to a threshold value. On the other hand, the control device 23 may not calculate the current capacity sigma for charging/discharging cycles in which the SOC change amount of at least one cell 111 is less than the threshold value. In addition, for example, the control device 23 may detect the current capacity sigma of each cell 111 using the SOC change amount for charging/discharging cycle in which the average value of the SOC change amounts of the cells 111 are greater than or equal to a threshold value. On the other hand, the control device 23 may not calculate the current capacity sigma for charging/discharging cycles in which the average value of the SOC change amounts of the cells 111 is less than the threshold value.

When the initial capacity value of each cell 111 is not known, the control device 23 may determine the initial capacity sigma of each cell 111 using Equation 2 above during initial use of the battery pack 10. That is, when the initial capacity value of each cell 111 is not known, the control device 23 may determine the initial capacity sigma using the SOC change amount of each cell 111 in the same manner as the method of determining the current capacity sigma.

On the other hand, although FIG. 1 illustrates a case in which the abnormally deteriorated cell detection apparatus 20 exists separately outside the battery pack 10, the abnormally deteriorated cell detection apparatus 20 may be integrated into the battery pack 10. In this case, the above-described functions of the deteriorated cell detection apparatus 20 may be performed by the BMS 12.

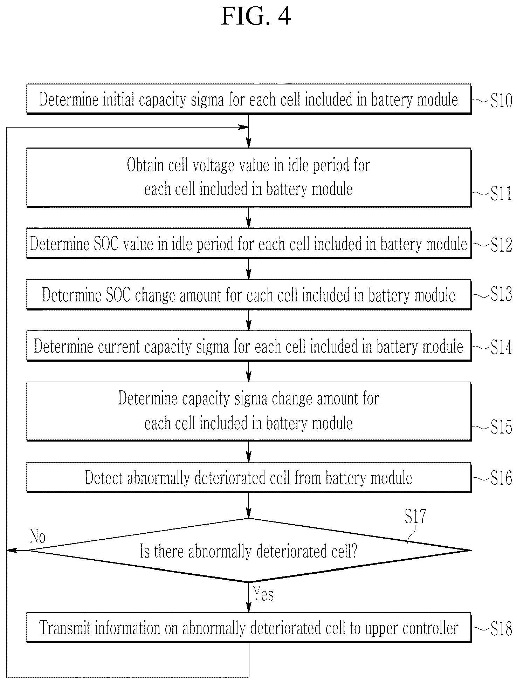

Hereinafter, an abnormally deteriorated cell detection method of the abnormally deteriorated cell detection apparatus 20 according to the embodiment will be described in detail with reference to FIG. 4. The abnormally deteriorated cell detection method of FIG. 4, which will be described later, may be performed by the control device 23 of the abnormally deteriorated cell detection apparatus 20 described with reference to FIG. 1.

FIG. 4 schematically illustrates the abnormally deteriorated cell detection method according to the embodiment.

Referring to FIG. 4, the abnormally deteriorated cell detection apparatus 20 according to the embodiment may determine an initial capacity sigma for each cell 111 included in the battery module 11 when the battery pack 10 is initially used (S10). In step S10, the abnormally deteriorated cell detection apparatus 20 may calculate the initial capacity sigma of each cell 111 using the initial capacity value of each cell 111 and Equation 1 above. The calculated initial capacity sigma may be used as a statistical value representing an initial capacity deviation between the cells 111 included in the battery module 11.

Thereafter, the abnormally deteriorated cell detection apparatus 20 may obtain a cell voltage value in the idle period for each cell 111 included in the battery module 11 (S11). The battery pack 10 may measure the cell voltage value of each cell 111 included in the battery module 11 in the idle period after charging and the idle period after discharging every charging/discharging cycle. Then, the battery pack 10 may transmit state data of each cell 111 including the cell voltage value measured in each idle period to the abnormally deteriorated cell detection apparatus 20.

The abnormally deteriorated cell detection apparatus 20 may determine each SOC value in the idle period for each cell 111 included in the battery module 11 by using the cell voltage value obtained through step S11 (S12). In step S12, the abnormally deteriorated cell detection apparatus 20 may determine the SOC value of each cell 111 using the cell voltage value of each cell 111 detected in each idle period and the preset OCV-SOC data.

The abnormally deteriorated cell detection apparatus 20 may determine the SOC change amount for each cell 111 included in the battery module 11 by using the SOC value determined through step S12 (S13). In step S13, the SOC change amount represents an amount in which the SOC of each cell 111 is changed by charging and discharging during a corresponding charging/discharging cycle. The abnormally deteriorated cell detection apparatus 20 may compare SOC values in two idle periods (the idle period after charging and the idle period after discharging) belonging to the same charging/discharging cycle to determine the SOC change amount of each cell 111. For example, the abnormally deteriorated cell detection apparatus 20 may determine the SOC change amount of each cell 111 by subtracting the SOC value in the idle period after discharging from the SOC value in the idle period after charging.

The abnormally deteriorated cell detection apparatus 20 may determine the current capacity sigma for each cell 111 included in the battery module 11 by using the SOC change amount of each cell 111 determined through step S13 (S14). In step S14, the abnormally deteriorated cell detection apparatus 20 may determine the current capacity sigma of each cell 111 using the SOC change amount of each cell 111 and Equation 2 above.

When the current capacity sigma of each cell 111 is determined, the abnormally deteriorated cell detection apparatus 20 may compare it with the initial capacity sigma to determine the amount of change in the capacity sigma of each cell 111 included in the battery module 11 (S15). In step S15, the abnormally deteriorated cell detection apparatus 20 may determine a difference value (current capacity sigma - initial capacity sigma) between the current capacity sigma and the initial capacity sigma as the amount of change in capacity sigma.

The abnormally deteriorated cell detection apparatus 20 may detect an abnormally deteriorated cell from the battery module 11 based on the amount of change in capacity sigma of each cell 111 determined through step S15 (S16).

In step S16, the abnormally deteriorated cell detection apparatus 20 may compare the amount of change in capacity sigma of each cell 111 with a threshold value. The abnormally deteriorated cell detection apparatus 20 may determine the cell 111 in which the amount of change in capacity sigma is greater than or equal to the threshold value as the abnormally deteriorated cell.

In step S16, the abnormally deteriorated cell detection apparatus 20 may detect an outlier among the amount of change in capacity sigma of the cells 111 using the Grubbs' test method. When the outlier is detected, the abnormally deteriorated cell detection apparatus 20 may determine the corresponding cell 111 as an abnormally deteriorated cell.

When it is determined that the abnormally deteriorated cell exists in the battery module 11 through step S16 (S17), the abnormally deteriorated cell detection apparatus 20 may transmit information on the abnormally deteriorated cell to the upper controller 30 (S18).

The abnormally deteriorated cell detection apparatus 20 may continuously perform step S11 to step S18 to continuously monitor the deterioration deviation of the cells 111 and detect abnormally deteriorated cells while the battery pack 10 is in use.

In the above description, in step S10, the abnormally deteriorated cell detection apparatus 20 determines the initial capacity sigma using the initial capacity value of each cell 111. However, if the abnormally deteriorated cell detection apparatus 20 does not know the initial capacity value of each cell 111, the initial capacity sigma of each cell 111 may be determined by performing the same steps as step S11 to step S14 during initial use of the battery pack 10.

The abnormally deteriorated cell detection apparatus 20 described above may be used to detect abnormally deteriorated cells in an energy storage system (ESS).

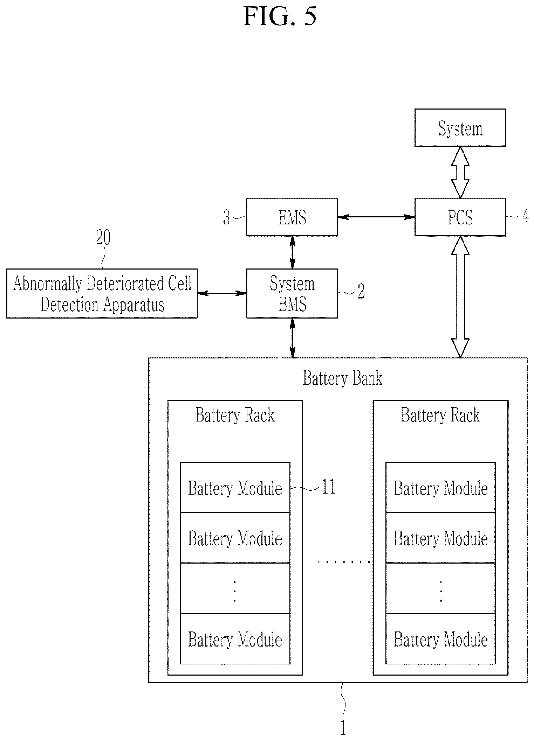

FIG. 5 illustrates an example of an energy storage system including the abnormally deteriorated cell detection apparatus according to the embodiment. The abnormally deteriorated cell detection apparatus 20 in the ESS of FIG. 5 corresponds to the abnormally deteriorated cell detection apparatus 20 described with reference to FIG. 1 to FIG. 4.

Referring to FIG. 5, the ESS may include a battery bank 1, a system BMS 2, an energy management system (EMS) 3, and a power conversion system (PCS) 4.

The battery bank 1 may include a plurality of cells (not shown) connected to one another in series or in parallel. For example, the battery bank 1 may include a plurality of battery racks (or battery systems) electrically connected to each other in series or in parallel. In addition, each battery rack may include a plurality of battery modules 11 electrically connected to each other in series or in parallel. In addition, each battery module 11 may include a plurality of cells (not shown) electrically connected to each other in series or in parallel.

The battery bank 1 may charge the battery bank 1 using electric energy supplied from a power system (not shown) through the PCS 4. In addition, the PCS 4 may supply electrical energy stored in the battery bank 1 to the power system through the PCS 4.

The PCS 4 may operate as a power conversion device that converts electrical characteristics (a DC, an AC, a voltage, a frequency, and the like) to transmit electrical energy between the battery bank 1 and the power system. Generally, electrical energy in the form of DC is used in the battery bank 1, and electrical energy in the form of AC is used in the power system. Therefore, the PCS 4 may transmit the electrical energy stored in the battery bank 1 to the power system through DC-AC conversion, or may transmit the electrical energy supplied from the power system to the battery bank 1 through AC-DC conversion.

In addition to the power conversion and distribution functions described above, the PCS 4 may also perform a function of controlling electricity quality, such as active power and reactive power of the ESS. The PCS 4 may perform a monitoring/control function that monitors the voltage and operation state of the ESS. The PCS 4 may also perform a grid-connected protection function that protects the power system during power outages. The PCS 4 may perform an independent operation function or the like for driving the ESS using the battery bank 1 even when there is no power source.

The battery bank 1 may be managed by the system BMS 2. The system BMS 2 may monitor the state of the battery bank 1 to control the battery bank 1 to operate in an optimal state. To this end, the system BMS 2 may perform a state (cell voltage, current, temperature, SOC, state of health (SOH)) monitoring function, a control function (for example, temperature control, cell balancing control), and a protection function (for example, overdischarging, overcharging, overcurrent prevention) for the battery cells configuring the battery bank 1.

The system BMS 2 may collect state data from the battery bank 1 (cell voltage value, SOC value, current value, temperature value, and the like) to monitor the state of the battery bank 1. The battery racks configuring the battery bank 1 may collect state data from the battery modules 11 included therein and transmit to the system BMS 2 the state data. The battery racks configuring the battery bank 1 may communicate with other battery racks or the system BMS 2 through controller area network (CAN) communication, and may transmit and receive data in a daisy chain method.

The EMS 3 is an integrated control device that monitors and controls the power use of the power system and the power supply of the ESS in real time for efficient energy operation of the ESS. The EMS 3 may monitor the state of the entire system (the battery bank 1, the system BMS 2, and the PCS 4) configuring the ESS and control the operation of the ESS.

The ESS may be operated to perform at least one charging/discharging cycle every day. One charging/discharging cycle may include a charging period, an idle period after charging, a discharging period, and an idle period after discharging.

The system BMS 2 may collect state data (cell voltage value, SOC value, and the like) of each battery module 11 configuring the battery bank 1 for each idle period. The system BMS 2 may transmit the collected state data to the abnormally deteriorated cell detection apparatus 20.

The abnormally deteriorated cell detection apparatus 20 receiving this may classify state data for each battery module 11 and perform a process for detecting an abnormally deteriorated cell for each battery module 11 using the classified state data. A method of detecting the abnormally deteriorated cell for each battery module 11 by the abnormally deteriorated cell detection apparatus 20 has been described in detail with reference to FIG. 1 to FIG. 4 above, so a redundant description thereof will be omitted.

On the other hand, although FIG. 5 illustrates a case in which the abnormally deteriorated cell detection apparatus 20 exists separately from the system BMS 2, the abnormally deteriorated cell detection apparatus 20 may be integrated into system BMS 2. In this case, the above-described functions of the deteriorated cell detection apparatus 20 may be performed by the system BMS 2.

As described above, the abnormally deteriorated cell detection apparatus 20 according to the embodiment may detect cells that are abnormally deteriorating at an early stage. Accordingly, safety problems such as ignition due to abnormally deteriorated cells may be prevented in advance.

While this invention has been described in connection with what is presently considered to be practical embodiments, it is to be understood that the invention is not limited to the disclosed embodiments, but, on the contrary, is intended to cover various modifications included within the scope of the appended claims.

**Claims**

1. An abnormally deteriorated cell detection method that detects an abnormally deteriorated cell of a battery module (11) including a plurality of cells (111), **characterised by** comprising:

   obtaining a first statistical value representing a capacity deviation at a first time point for the plurality of cells (111) (S10);
   obtaining a second statistical value representing a capacity deviation at a second time point for the plurality of cells (111) (S14); and
   comparing the first statistical value and the second statistical value (S15) to detect an abnormally deteriorated cell (S16).

2. The abnormally deteriorated cell detection method as claimed in claim 1, wherein the obtaining of the first statistical value includes obtaining the first statistical value using an initial capacity value of each of the plurality of cells (111),

   the initial capacity value corresponding to a formation capacity of each cell (111),
   and wherein optionally the obtaining of the first statistical value using the initial capacity value includes:

      obtaining an average value and a standard deviation of the initial capacity values for the plurality of cells (111);
      calculating a first sigma using the initial capacity value, the average value, and the standard deviation, for each of the plurality of cells (111); and
      obtaining the first sigma calculated for each of the plurality of cells (111) as the first statistical value.

3. The abnormally deteriorated cell detection method as claimed in claim 1, wherein the obtaining of the first statistical value includes:

   detecting a first state of charge (SOC) change amount during a first period for each of the plurality of cells (111) (S13);
   obtaining an average value and a standard deviation of the first SOC change amount for the plurality of cells (111);
   calculating a second sigma using the first SOC change amount, the average value, and the standard deviation, for each of the plurality of cells (111); and
   determining the second sigma calculated for each of the plurality of cells (111) as the first statistical value, wherein optionally the detecting of the first SOC change amount includes:

      detecting a first SOC value of each of the plurality of cells (111) in a first idle period of the battery module (11);
      detecting a second SOC value of each of the plurality of cells (111) in a second idle period after the first idle period of the battery module (11); and

calculating the first SOC change amount from a difference value between the first SOC value and the second SOC value, for each of the plurality of cells (111),
and wherein further optionally:

the detecting of the first SOC value includes:

obtaining a first cell voltage value detected at a predetermined time elapsed from a starting time point of the first idle period, for each of the plurality of cells (111) (S11); and
determining the first SOC value using the first cell voltage value for each of the plurality of cells (111) (S12); and

the detecting of the second SOC value includes:

obtaining a second cell voltage value detected at a predetermined time elapsed from a starting time point of the second idle period, for each of the plurality of cells (111) (S11); and
determining the second SOC value using the second cell voltage value for each of the plurality of cells (111) (S12).

4. The abnormally deteriorated cell detection method as claimed in any preceding claim, wherein the obtaining of the second statistical value includes:

detecting a second SOC change amount during a second period for each of the plurality of cells (111) (S13),
obtaining an average value and a standard deviation of the second SOC change amount for the plurality of cells (111),
calculating a third sigma using the SOC change amount, the average value, and the standard deviation, for each of the plurality of cells (111), and
determining the third sigma calculated for each of the plurality of cells (111) as the second statistical value.

5. The abnormally deteriorated cell detection method as claimed in claim 4, wherein the detecting of the second SOC change amount includes:

detecting a third SOC value of each of the plurality of cells (111) in a third idle period of the battery module (11);
detecting a fourth SOC value of each of the plurality of cells (111) in a fourth idle period after the third idle period of the battery module (11); and
calculating the second SOC change amount from a difference value between the third SOC value and the fourth SOC value, for each of the plurality of cells (111),
and wherein optionally:

the detecting of the third SOC value includes:

obtaining a third cell voltage value detected at a predetermined time elapsed from a starting time point of the third idle period, for each of the plurality of cells (111) (S11), and
determining the third SOC value using the third cell voltage value for each of the plurality of cells (111) (S12),

the detecting of the fourth SOC value includes:

obtaining a fourth cell voltage value detected at a predetermined time elapsed from a starting time point of the fourth idle period, for each of the plurality of cells (111) (S11), and
determining the fourth SOC value using the fourth cell voltage value for each of the plurality of cells (111) (S12).

6. The abnormally deteriorated cell detection method as claimed in claim 4, wherein the detecting of the second SOC change amount includes:

detecting a fourth SOC change amount between an idle period after charging and an idle period after discharging for each charging/discharging cycle, for each of the plurality of cells (111); and
determining the second SOC change amount from an average value of the fourth SOC change amount detected during the second period,
the second period including at least one charging/discharging cycle.

7. The abnormally deteriorated cell detection method as claimed in any preceding claim, wherein the detecting of the abnormally deteriorated cell includes:

comparing a difference value between the first statistical value and the second statistical value with a threshold value, and
determining a cell (111) whose difference value is greater than or equal to the threshold value as an abnormally deteriorated cell.

8. The abnormally deteriorated cell detection method as claimed in any one of claims 1 to 7, wherein the detecting of the abnormally deteriorated cell includes:

calculating a difference value between the first statistical value and the second statistical value for each of the plurality of cells (111);
using a Grubbs' test method to detect an outlier among the difference values for each of the plurality of cells (111); and
determining a cell (111) whose difference value is an outlier among the plurality of cells (111) as an abnormally deteriorated cell.

9. An abnormally deteriorated cell detection apparatus (20) that detects an abnormally deteriorated cell of a battery module (11) including a plurality of cells (111), **characterised by** comprising:
a control device (23) configured to:

obtain a first statistical value representing a capacity deviation at a first time point for the plurality of cells (111);
obtain a second statistical value representing a capacity deviation at a second time point for the plurality of cells (111); and
detect an abnormally deteriorated cell by comparing the first statistical value and the second statistical value with each other.

10. The abnormally deteriorated cell detection apparatus (20) as claimed in claim 9, further comprising a storage device (22) that stores an initial capacity value of the plurality of cells (111),
wherein the control device (23) is further configured to:

calculate a first sigma of each of the plurality of cells (111) using the initial capacity value of each of the plurality of cells (111) and an average value and a standard deviation of the initial capacity values of the plurality of cells (111); and
use the first sigma calculated for each of the plurality of cells (111) as the first statistical value,
the initial capacity value corresponding to a formation capacity of each cell (111).

11. The abnormally deteriorated cell detection apparatus (20) as claimed in claim 9 or 10, wherein the control device (23) is further configured to:

detect a first SOC change amount during a first period for the plurality of cells (111);
calculate an average value and a standard deviation of the first SOC change amount for the plurality of cells (111);
calculate a second sigma of each of the plurality of cells (111) using the first SOC change amount, the average value, and the standard deviation; and
use the second sigma calculated for each of the plurality of cells (111) as the first statistical value,
and wherein optionally the control device (23) is further configured to:

use a first cell voltage value detected at a predetermined time elapsed from a starting time point of an idle period after first charging for each of the plurality of cells (111) to determine a first SOC value in the idle period after the first charging;
use a second cell voltage value detected at a predetermined time elapsed from a starting time point of an idle period after first discharging for each of the plurality of cells (111) to determine a second SOC value in the idle period after the first discharging; and
determine the first SOC change amount from a difference value between the first SOC value and the second SOC value.

12. The abnormally deteriorated cell detection apparatus (20) as claimed in claim 9, 10 or 11, wherein the control device (23) is further configured to:

detect a second SOC change amount during a second period for the plurality of cells (111);
calculate an average value and a standard deviation of the second SOC change amount for the plurality of cells (111);
calculate a third sigma of each of the plurality of cells (111) using the second SOC change amount, the average value, and the standard deviation; and
use the third sigma calculated for each of the plurality of cells (111) as the second statistical value.

13. The abnormally deteriorated cell detection apparatus (20) as claimed in claim 12, wherein the control device (23) is further configured to:

use a third cell voltage value detected at a predetermined time elapsed from a starting time point of an idle period after second charging for each of the plurality of cells (111) to determine a third SOC value in the idle period after the second charging;
use a fourth cell voltage value detected at a predetermined time elapsed from a starting time point of an idle period after second discharging for each of the plurality of cells (111) to determine a fourth SOC value in the idle period after the second discharging; and
determine the second SOC change amount from a difference value between the third SOC value and the fourth SOC value.

14. The abnormally deteriorated cell detection apparatus (20) as claimed in claim 12, wherein the control device (23) is further configured to:

detect, for each of the plurality of cells (111), a fourth SOC change amount between an idle period after charging and an idle period after discharging for each charging cycle during the second period; and
determine the second SOC change amount from an average value of the fourth SOC change amount detected during the second period, and
the second period includes at least one charging/discharging cycle.

15. The abnormally deteriorated cell detection apparatus (20) as claimed in claim 13, wherein the control device (23) is further configured to:

compare a difference value between the first statistical value and the second statistical value with a threshold value; and
determine a cell (111) whose difference value is greater than or equal to the threshold value as an abnormally deteriorated cell.


**Patentansprüche**

1. Verfahren zur Erkennung abnormal verschlechterter Zellen eines Batteriemoduls (11), das eine Vielzahl von Zellen (111) einschließt, **dadurch gekennzeichnet, dass** es Folgendes umfasst:

Erhalten eines ersten statistischen Werts, der eine Kapazitätsabweichung zu einem ersten Zeitpunkt für die Vielzahl von Zellen (111) darstellt (S10);
Erhalten eines zweiten statistischen Werts, der eine Kapazitätsabweichung zu einem zweiten Zeitpunkt für die Vielzahl von Zellen (111) (S14) darstellt; und
Vergleichen des ersten statistischen Werts mit dem zweiten statistischen Wert (S15), um eine abnormal verschlechterte Zelle (S16) zu erkennen.

2. Verfahren zur Erkennung abnormal verschlechterter Zellen nach Anspruch 1, wobei das Erhalten des ersten statistischen Werts Erhalten des ersten statistischen Werts unter Verwendung eines anfänglichen Kapazitätswerts jeder der Vielzahl von Zellen (111) einschließt,

wobei der anfängliche Kapazitätswert einer Formierungskapazität jeder Zelle (111) entspricht,
und wobei das Erhalten des ersten statistischen Werts unter Verwendung des anfänglichen Kapazitätswertes optional Folgendes einschließt:

Erhalten eines Mittelwerts und einer Standardabweichung der anfänglichen Kapazitätswerte für die Vielzahl von Zellen (111);
Berechnen eines ersten Sigmas unter Verwendung des anfänglichen Kapazitätswerts, des Mittelwerts und der Standardabweichung für jede der Vielzahl von Zellen (111); und
Erhalten des ersten Sigmas, das für jede der Vielzahl von Zellen (111) berechnet wurde, als den ersten statistischen Wert.

3. Verfahren zur Erkennung abnormal verschlechterter Zellen nach Anspruch 1, wobei das Erhalten des ersten statistischen Werts Folgendes einschließt:

Erkennen einer ersten Änderungsausmaßes des Ladezustands (SOC) während eines ersten Zeitraums für jede der Vielzahl von Zellen (111) (S13);
Erhalten eines Mittelwerts und einer Standardabweichung des ersten SOC-Änderungsausmaßes für die Vielzahl von Zellen (111);
Berechnen eines zweiten Sigmas unter Verwendung des ersten SOC-Änderungsausmaßes, des Mittelwerts und der Standardabweichung für jede der Vielzahl von Zellen (111); und
Bestimmen des zweiten Sigmas, der für jede der Vielzahl von Zellen (111) berechnet wird, als den ersten statistischen Wert,
wobei das Erkennen des ersten SOC-Änderungsausmaßes optional Folgendes einschließt:

Erkennen eines ersten SOC-Werts jeder der Vielzahl von Zellen (111) während einer ersten Leerlaufperiode des Batteriemoduls (11);
Erkennen eines zweiten SOC-Werts jeder der Vielzahl von Zellen (111) in einer zweiten Leerlaufperiode nach der ersten Leerlaufperiode des Batteriemoduls (11); und
Berechnen des ersten SOC-Änderungsausmaßes aus einer Differenz zwischen dem ersten SOC-Wert und dem zweiten SOC-Wert für jede der Vielzahl von Zellen (111),
und wobei weiter optional:

das Erkennen des ersten SOC-Werts Folgendes einschließt:

Erhalten eines ersten Zellspannungswerts, der zu einer vorbestimmten Zeit erkannt wird, die ab einem Startzeitpunkt der ersten Leerlaufperiode für jede der Vielzahl von Zellen (111) (S11) verstrichen ist; und
Bestimmen des ersten SOC-Werts unter Verwendung des ersten Zellspannungswerts für jede der Vielzahl von Zellen (111) (S12); und

das Erkennen des zweiten SOC-Werts Folgendes einschließt:

Erhalten eines zweiten Zellspannungswerts, der zu einer vorbestimmten Zeit erkannt wird, die ab einem Startzeitpunkt der zweiten Leerlaufperiode für jede der Vielzahl von Zellen (111) (S11) verstrichen ist; und
Bestimmen des zweiten SOC-Werts unter Verwendung des zweiten Zellspannungswerts für jede der Vielzahl von Zellen (111) (S12).

4. Verfahren zur Erkennung abnormal verschlechterter Zellen nach einem vorstehenden Anspruch, wobei das Erhalten des zweiten statistischen Werts Folgendes einschließt:

Erkennen eines zweiten SOC-Änderungsausmaßes während eines zweiten Zeitraums für jede der Vielzahl von Zellen (111) (S13),
Erhalten eines Mittelwerts und einer Standardabweichung des zweiten SOC-Änderungsausmaßes für die Vielzahl von Zellen (111),
Berechnen eines dritten Sigmas unter Verwendung des SOC-Änderungsausmaßes, des Mittelwerts und der Standardabweichung für jede der Vielzahl von Zellen (111), und
Bestimmen des dritten Sigmas, das für jede der Vielzahl von Zellen (111) berechnet wurde, als den zweiten statistischen Wert.

**5.** Verfahren zur Erkennung abnormal verschlechterter Zellen nach Anspruch 4, wobei das Erkennen des zweiten SOC-Änderungsausmaßes Folgendes einschließt:

Erkennen eines dritten SOC-Werts jeder der Vielzahl von Zellen (111) während einer dritten Leerlaufperiode des Batteriemoduls (11);
Erkennen eines vierten SOC-Werts jeder der Vielzahl von Zellen (111) in einer vierten Leerlaufperiode nach der dritten Leerlaufperiode des Batteriemoduls (11); und
Berechnen des zweiten SOC-Änderungsausmaßes aus einer Differenz zwischen dem dritten SOC-Wert und dem vierten SOC-Wert für jede der Vielzahl von Zellen (111),
und wobei optional:

das Erhalten des dritten SOC-Werts Folgendes einschließt:

Erhalten eines dritten Zellspannungswerts, der zu einer vorbestimmten Zeit erkannt wird, die ab einem Startzeitpunkt der dritten Leerlaufperiode für jede der Vielzahl von Zellen (111) (S11) verstrichen ist, und Bestimmen des dritten SOC-Werts unter Verwendung des dritten Zellspannungswerts für jede der Vielzahl von Zellen (111) (S12),

das Erhalten des vierten SOC-Werts Folgendes einschließt:

Erhalten eines vierten Zellspannungswerts, der zu eine vorbestimmten Zeit erkannt wird, die ab einem Startzeitpunkt der vierten Leerlaufperiode für jede der Vielzahl von Zellen (111) (S11) verstrichen ist, und Bestimmen des vierten SOC-Werts unter Verwendung des vierten Zellspannungswerts für jede der Vielzahl von Zellen (111) (S12).

**6.** Verfahren zur Erkennung abnormal verschlechterter Zellen nach Anspruch 4, wobei das Erkennen des zweiten SOC-Änderungsausmaßes Folgendes einschließt:

Erkennen eines vierten SOC-Änderungsausmaßes zwischen einer Leerlaufperiode nach Laden und einer Leerlaufperiode nach Entladen für jeden Lade-/Entladungszyklus für jede der Vielzahl von Zellen (111); und Bestimmen des zweiten SOC-Änderungsausmaßes aus einem Durchschnittswert des vierten SOC-Änderungsausmaßes, der während des zweiten Zeitraums erkannt wurde,
wobei der zweite Zeitraum mindestens einen Lade-/Entladungszyklus einschließt.

**7.** Verfahren zum Erkennen abnormal verschlechterter Zellen nach einem vorstehenden Anspruch, wobei das Erkennen der abnormal verschlechterten Zelle Folgendes einschließt:

Vergleichen eines Differenzwertes zwischen dem ersten statistischen Wert und dem zweiten statistischen Wert mit einem Schwellenwert, und
Bestimmen einer Zelle (111), deren Differenzwert größer oder gleich groß wie der Schwellenwert ist, als abnormal verschlechterte Zelle.

**8.** Verfahren zum Erkennen abnormal verschlechterter Zellen nach einem der Ansprüche 1 bis 7, wobei das Erkennen der abnormal verschlechterten Zelle Folgendes einschließt:

Berechnen eines Differenzwertes zwischen dem ersten statistischen Wert und dem zweiten statistischen Wert für jede der Vielzahl von Zellen (111);
Verwenden eines Grubbs-Testverfahrens, um einen Ausreißer unter den Differenzwerten für jede der Vielzahl von Zellen zu erkennen (111); und
Bestimmen einer Zelle (111), deren Differenzwert unter der Vielzahl von Zellen (111) ein Ausreißer ist, als abnormal verschlechterte Zelle.

**9.** Einrichtung (20) zur Erkennung abnormal verschlechterter Zellen eines Batteriemoduls (11), das eine Vielzahl von Zellen (111) einschließt, **dadurch gekennzeichnet, dass** sie Folgendes umfasst:
eine Steuervorrichtung (23), die konfiguriert ist zum:

Erhalten eines ersten statistischen Werts, der eine Kapazitätsabweichung zu einem ersten Zeitpunkt für die Vielzahl von Zellen darstellt (111);

Erhalten eines zweiten statistischen Werts, der eine Kapazitätsabweichung zu einem zweiten Zeitpunkt für die Vielzahl von Zellen (111) darstellt; und

Erkennen einer abnormal verschlechterten Zelle durch Vergleichen des ersten statistischen Werts und des zweiten statistischen Werts miteinander.

10. Einrichtung (20) zur Erkennung abnormal verschlechterter Zellen nach Anspruch 9, weiter umfassend eine Speichervorrichtung (22), die einen anfänglichen Kapazitätswert der Vielzahl von Zellen (111) speichert,

wobei die Steuervorrichtung (23) weiter konfiguriert ist zum:

Berechnen eines ersten Sigmas für jede der Zellen (111) unter Verwendung des anfänglichen Kapazitätswerts jeder der Vielzahl von Zellen (111) und eines Mittelwerts und einer Standardabweichung von den anfänglichen Kapazitätswerten der Vielzahl von Zellen (111); und

Verwenden des ersten für jede der Vielzahl von Zellen (111) berechneten Sigmas als den ersten statistischen Wert,

wobei der anfängliche Kapazitätswert einer Formierungskapazität jeder Zelle (111) entspricht.

11. Einrichtung (20) zur Erkennung abnormal verschlechterter Zellen nach Anspruch 9 oder 10, wobei die Steuervorrichtung (23) weiter konfiguriert ist zum:

Erkennen eines ersten SOC-Änderungsausmaßes während eines ersten Zeitraums für die Vielzahl von Zellen (111);

Berechnen eines Mittelwerts und einer Standardabweichung des ersten SOC-Änderungsausmaßes für die Vielzahl von Zellen (111);

Berechnen eines zweiten Sigmas für jede der Vielzahl von Zellen (111) unter Verwendung des ersten SOC-Änderungsausmaßes, des Mittelwerts und der Standardabweichung; und

Verwenden des für jede der Vielzahl von Zellen (111) berechneten zweiten Sigmas als den ersten statistischen Wert,

und wobei die Steuervorrichtung (23) optional weiter konfiguriert ist zum:

Verwenden eines ersten Zellspannungswerts, der zu einer vorbestimmten Zeit erkannt wird, die ab einem Startzeitpunkt einer Leerlaufperiode nach erstem Laden jeder der Vielzahl von Zellen (111) verstrichen ist, um einen ersten SOC-Wert in der Leerlaufperiode nach dem ersten Laden zu bestimmen;

Verwenden eines zweiten Zellspannungswerts, der zu einer vorbestimmten Zeit erkannt wird, die ab einem Startzeitpunkt einer Leerlaufperiode nach erstem Entladen jeder der Vielzahl von Zellen (111) verstrichen ist, um einen zweiten SOC-Wert in der Leerlaufperiode nach dem ersten Entladen zu bestimmen; und

Bestimmen des ersten SOC-Änderungsausmaßes aus einer Differenz zwischen dem ersten SOC-Wert und dem zweiten SOC-Wert.

12. Einrichtung (20) zur Erkennung abnormal verschlechterter Zellen nach Anspruch 9, 10 oder 11, wobei die Steuervorrichtung (23) weiter konfiguriert ist zum:

Erkennen eines zweiten SOC-Änderungsausmaßes während eines zweiten Zeitraums für die Vielzahl von Zellen (111);

Berechnen eines Mittelwerts und einer Standardabweichung des zweiten SOC-Änderungsausmaßes für die Vielzahl von Zellen (111);

Berechnen eines zweiten Sigmas für jede der Vielzahl von Zellen (111) unter Verwendung des zweiten SOC-Änderungsausmaßes, des Mittelwerts und der Standardabweichung; und

Verwenden des dritten Sigmas, das für jede der Vielzahl von Zellen (111) berechnet wurde, als den zweiten statistischen Wert.

13. Einrichtung (20) zur Erkennung abnormal verschlechterter Zellen nach Anspruch 12, wobei die Steuervorrichtung (23) weiter konfiguriert ist zum:

Verwenden eines dritten Zellspannungswerts, der zu einer vorbestimmten Zeit erkannt wird, die ab einem Startzeitpunkt einer Leerlaufperiode nach zweitem Laden jeder der Vielzahl von Zellen (111) verstrichen ist, um einen dritten SOC-Wert in der Leerlaufperiode nach dem zweiten Laden zu bestimmen;

Verwenden eines vierten Zellspannungswerts, der zu einer vorbestimmten Zeit erkannt wird, die ab einem Startzeitpunkt einer Leerlaufperiode nach zweitem Entladen jeder der Vielzahl von Zellen (111) verstrichen ist, um einen vierten SOC-Wert in der Leerlaufperiode nach dem zweiten Entladen zu bestimmen; und

Bestimmen des zweiten SOC-Änderungsausmaßes aus einer Differenz zwischen dem dritten SOC-Wert und dem vierten SOC-Wert.

**14.** Einrichtung (20) zur Erkennung abnormal verschlechterter Zellen nach Anspruch 12, wobei die Steuervorrichtung (23) weiter konfiguriert ist zum:

Erkennen für jede der Vielzahl von Zellen (111) eines vierten SOC-Änderungsausmaßes zwischen einer Leerlaufperiode nach Laden und einer Leerlaufperiode nach Entladen für jeden Ladezyklus während des zweiten Zeitraums; und

Bestimmen des zweiten SOC-Änderungsausmaßes aus einem Durchschnittswert des vierten SOC-Änderungsausmaßes, der während des zweiten Zeitraums erkannt wurde, sowie

wobei der zweite Zeitraum mindestens einen Lade-/Entladungszyklus einschließt.

**15.** Einrichtung (20) zur Erkennung abnormal verschlechterter Zellen nach Anspruch 13, wobei die Steuervorrichtung (23) weiter konfiguriert ist zum:

Vergleichen eines Differenzwertes zwischen dem ersten statistischen Wert und dem zweiten statistischen Wert mit einem Schwellenwert; und

Bestimmen einer Zelle (111), deren Differenzwert größer oder gleich groß wie der Schwellenwert ist, als abnormal verschlechterte Zelle.

**Revendications**

**1.** Procédé de détection de cellule anormalement détériorée qui détecte une cellule anormalement détériorée d'un module de batterie (11) incluant plusieurs cellules (111), **caractérisé en ce qu'**il comprend

l'obtention d'une première valeur statistique représentant un écart de capacité à un premier point temporel pour la pluralité de cellules (111) (S10) ;

l'obtention d'une seconde valeur statistique représentant un écart de capacité à un second point temporel pour la pluralité de cellules (111) (S14) ; et

la comparaison de la première valeur statistique et la seconde valeur statistique (S15) pour détecter une cellule anormalement détériorée (S16).

**2.** Procédé de détection de cellule anormalement détériorée selon la revendication 1, dans lequel l'obtention de la première valeur statistique inclut l'obtention de la première valeur statistique à l'aide d'une valeur de capacité initiale de chacune de la pluralité de cellules (111),

la valeur de capacité initiale correspondant à une capacité de formation de chaque cellule (111),

et dans lequel éventuellement l'obtention de la première valeur statistique à l'aide de la valeur de capacité initiale inclut :

l'obtention d'une valeur moyenne et d'un écart type des valeurs de capacité initiales pour la pluralité de cellules (111) ;

le calcul d'un premier sigma à l'aide de la valeur de capacité initiale, la valeur moyenne et l'écart type, pour chacune de la pluralité de cellules (111) ; et

l'obtention du premier sigma calculé pour chacune de la pluralité de cellules (111) comme première valeur statistique.

**3.** Procédé de détection de cellule anormalement détériorée selon la revendication 1, dans lequel l'obtention de la première valeur statistique inclut :

la détection d'une première quantité de changement d'état de charge (SOC) dans une première période pour chacune de la pluralité de cellules (111) (S13) ;

l'obtention d'une valeur moyenne et d'un écart type de la première quantité de changement SOC pour la pluralité de cellules (111) ;

le calcul d'un deuxième sigma à l'aide de la première quantité de changement SOC, la valeur moyenne et l'écart type, pour chacune de la pluralité de cellules (111) ; et

la détermination du deuxième sigma calculé pour chacune de la pluralité de cellules (111) comme première valeur statistique,

dans lequel éventuellement la détection de la première quantité de changement SOC inclut :

la détection d'une première valeur SOC de chacune de la pluralité de cellules (111) dans une première période d'inactivité du module de batterie (11) ;

la détection d'une deuxième valeur SOC de chacune de la pluralité de cellules (111) dans une deuxième période d'inactivité après la première période d'inactivité du module de batterie (11) ; et

le calcul de la première quantité de changement SOC à l'aide de la différence entre la première valeur SOC et la deuxième valeur SOC, pour chacune de la pluralité de cellules (111),

et dans lequel en outre éventuellement :

la détection de la première valeur SOC inclut :

l'obtention d'une première valeur de tension de cellule détectée à un temps prédéterminé écoulé depuis un point temporel de début de la première période d'inactivité, pour chacune de la pluralité de cellules (111) (S11) ; et

la détermination de la première valeur SOC à l'aide de la première valeur de tension de cellule pour chacune de la pluralité de cellules (111) (S12) ; et

la détection de la deuxième valeur SOC inclut :

l'obtention d'une deuxième valeur de tension de cellule détectée à un temps prédéterminé écoulé depuis le point temporel de début de la deuxième période d'inactivité, pour chacune de la pluralité de cellules (111) (S11) ; et

la détermination de la deuxième valeur SOC à l'aide de la deuxième valeur de tension de cellule pour chacune de la pluralité de cellules (111) (S12).

4. Procédé de détection de cellule anormalement détériorée selon une quelconque revendication précédente, dans lequel l'obtention de la seconde valeur statistique inclut :

la détection d'une deuxième quantité de changement SOC dans une deuxième période pour chacune de la pluralité de cellules (111) (S13),

l'obtention d'une valeur moyenne et d'un écart type de la deuxième quantité de changement SOC pour la pluralité de cellules (111),

le calcul d'un troisième sigma à l'aide de la quantité de changement SOC, de la valeur moyenne et de l'écart type, pour chacune de la pluralité de cellules (111), et

la détermination du troisième sigma calculé pour chacune de la pluralité de cellules (111) comme seconde valeur statistique.

5. Procédé de détection de cellule anormalement détériorée selon la revendication 4, dans lequel la détection de la deuxième quantité de changement SOC inclut :

la détection d'une troisième valeur SOC de chacune de la pluralité de cellules (111) dans une troisième période d'inactivité du module de batterie (11) ;

la détection d'une quatrième valeur SOC de chacune de la pluralité de cellules (111) dans une quatrième période d'inactivité après la troisième période d'inactivité du module de batterie (11) ; et

le calcul de la deuxième quantité de changement SOC à l'aide d'une différence entre la troisième valeur SOC et la quatrième valeur SOC, pour chacune de la pluralité de cellules (111),

et dans lequel éventuellement :

la détection de la troisième valeur SOC inclut :

l'obtention d'une troisième valeur de tension de cellule détectée à un temps prédéterminé écoulé depuis un point temporel de début de la troisième période d'inactivité, pour chacune de la pluralité de cellules (111) (S11), et
la détermination de la troisième valeur SOC à l'aide de la troisième valeur de tension de cellule pour chacune de la pluralité de cellules (111) (S12),

la détection de la quatrième valeur SOC inclut :

l'obtention d'une quatrième valeur de tension de cellule détectée à un temps prédéterminé écoulé depuis un point temporel de début de la quatrième période d'inactivité, pour chacune de la pluralité de cellules (111) (S11), et
la détermination de la quatrième valeur SOC à l'aide de la quatrième valeur de tension de cellule pour chacune de la pluralité de cellules (111) (S12).

6. Procédé de détection de cellule anormalement détériorée selon la revendication 4, dans lequel la détection de la deuxième quantité de changement SOC inclut :

la détection d'une quatrième quantité de changement SOC entre une période d'inactivité après la charge et une période d'inactivité après la décharge pour chaque cycle de charge/décharge, pour chacune de la pluralité de cellules (111) ; et
la détermination de la deuxième quantité de changement SOC à partir d'une valeur moyenne de la quatrième quantité de changement SOC détectée dans la deuxième période,
la deuxième période incluant au moins un cycle de charge/décharge.

7. Procédé de détection de cellule anormalement détériorée selon une quelconque revendication précédente, dans lequel la détection de la cellule anormalement détériorée inclut :

la comparaison de la différence entre la première valeur statistique et la seconde valeur statistique à une valeur seuil, et
la détermination d'une cellule (111) dont la valeur de différence est supérieure ou égale à la valeur seuil comme cellule anormalement détériorée.

8. Procédé de détection de cellule anormalement détériorée selon l'une quelconque des revendications 1 à 7, dans lequel la détection de la cellule anormalement détériorée inclut :

le calcul d'une valeur de différence entre la première valeur statistique et la seconde valeur statistique pour chacune de la pluralité de cellules (111) ;
l'utilisation de la méthode du test de Grubbs pour détecter une valeur aberrante parmi les valeurs de différence pour chacune de la pluralité de cellules (111) ; et
la détermination d'une cellule (111) dont la valeur de différence est une valeur aberrante parmi la pluralité de cellules (111) comme cellule anormalement détériorée.

9. Appareil de détection de cellule anormalement détériorée (20) qui détecte une cellule anormalement détériorée d'un module de batterie (11) incluant une pluralité de cellules (111), **caractérisé en ce qu'**il comprend :
un dispositif de commande (23) configuré pour :

obtenir une première valeur statistique représentant un écart de capacité à un premier point temporel pour la pluralité de cellules (111) ;
obtenir une seconde valeur statistique représentant un écart de capacité à un second point temporel pour la pluralité de cellules (111) ; et
détecter une cellule anormalement détériorée en comparant la première valeur statistique et la seconde valeur statistique l'une à l'autre.

10. Appareil de détection de cellule anormalement détériorée (20) selon la revendication 9, comprenant en outre un dispositif de stockage (22) qui stocke une valeur de capacité initiale de la pluralité de cellules (111),
dans lequel le dispositif de commande (23) est en outre configuré pour :

calculer un premier sigma de chacune de la pluralité de cellules (111) à l'aide de la valeur de capacité initiale de chacune de la pluralité de cellules (111) et une valeur moyenne et un écart type des valeurs de capacité initiales des cellules (111) ; et

utiliser le premier sigma calculé pour chacune de la pluralité de cellules (111) comme première valeur statistique, la valeur de capacité initiale correspondant à une capacité de formation de chaque cellule (111).

11. Appareil de détection de cellule anormalement détériorée (20) selon la revendication 9 ou 10, dans lequel le dispositif de commande (23) est en outre configuré pour :

détecter une première quantité de changement SOC dans une première période pour la pluralité de cellules (111) ;
calculer une valeur moyenne et un écart type de la première quantité de changement SOC pour la pluralité de cellules (111) ;
calculer un deuxième sigma de chacune de la pluralité de cellules (111) à l'aide de la première quantité de changement SOC, la valeur moyenne et l'écart type ; et
utiliser le deuxième sigma calculé pour chacune de la pluralité de cellules (111) comme première valeur statistique,
et dans lequel éventuellement le dispositif de commande (23) est en outre configuré pour :

utiliser une première valeur de tension de cellule détectée à un temps prédéterminé écoulé depuis un point temporel de début d'une période d'inactivité après la première charge pour chacune de la pluralité de cellules (111) afin de déterminer une première valeur SOC dans la période d'inactivité après la première charge ;
utiliser une deuxième valeur de tension de cellule détectée à un temps prédéterminé écoulé depuis un point temporel de début d'une période d'inactivité après la première décharge pour chacune de la pluralité de cellules (111) afin de déterminer une deuxième valeur SOC dans la période d'inactivité suivant la première décharge ; et
déterminer la première quantité de changement SOC à l'aide de la différence entre la première valeur SOC et la deuxième valeur SOC.

12. Appareil de détection de cellule anormalement détériorée (20) selon la revendication 9, 10 ou 11, dans lequel le dispositif de commande (23) est en outre configuré pour :

détecter une deuxième quantité de changement SOC dans une deuxième période pour la pluralité de cellules (111) ;
calculer une valeur moyenne et un écart type de la deuxième quantité de changement SOC pour la pluralité de cellules (111) ;
calculer un troisième sigma de chacune de la pluralité de cellules (111) à l'aide de la deuxième quantité de changement SOC, la valeur moyenne et l'écart type ; et
utiliser le troisième sigma calculé pour chacune de la pluralité de cellules (111) comme seconde valeur statistique.

13. Appareil de détection de cellule anormalement détériorée (20) selon la revendication 12, dans lequel le dispositif de commande (23) est en outre configuré pour :

utiliser une troisième valeur de tension de cellule détectée à un temps prédéterminé écoulé depuis un point temporel de début d'une période d'inactivité après la deuxième charge pour chacune de la pluralité de cellules (111) afin de déterminer une troisième valeur SOC dans la période d'inactivité après la deuxième charge ;
utiliser une quatrième valeur de tension de cellule détectée à un temps prédéterminé écoulé depuis un point temporel de début d'une période d'inactivité après la deuxième décharge pour chacune de la pluralité de cellules (111) afin de déterminer une quatrième valeur SOC dans la période d'inactivité après la deuxième décharge ; et
déterminer la deuxième quantité de changement SOC à partir d'une valeur de différence entre la troisième valeur SOC et la quatrième valeur SOC.

14. Appareil de détection de cellule anormalement détériorée (20) selon la revendication 12, dans lequel le dispositif de commande (23) est en outre configuré pour :

détecter, pour chacune de la pluralité de cellules (111), une quatrième quantité de changement SOC entre une période d'inactivité après la charge et une période d'inactivité après la décharge pour chaque cycle de charge dans la deuxième période ; et
déterminer la deuxième quantité de changement SOC à partir d'une valeur moyenne de la quatrième quantité de changement SOC détectée dans la deuxième période, et
la deuxième période inclut au moins un cycle de charge/décharge.

**15.** Appareil de détection de cellule anormalement détériorée (20) selon la revendication 13, dans lequel le dispositif de commande (23) est en outre configuré pour :

comparer une valeur de différence entre la première valeur statistique et la seconde valeur statistique à une valeur seuil ; et
déterminer une cellule (111) dont la valeur de différence est supérieure ou égale à la valeur seuil comme cellule anormalement détériorée.

# FIG. 1

FIG. 2

Legend:
● Initial Capacity Sigma
■ Current Capacity Sigma

X-axis: Cell Number (Cell #1 through Cell #10)
Y-axis: Capacity Sigma

# FIG. 3

# FIG. 4

Determine initial capacity sigma for each cell included in battery module —S10

Obtain cell voltage value in idle period for
each cell included in battery module —S11

Determine SOC value in idle period for each cell included in battery module —S12

Determine SOC change amount for each cell included in battery module —S13

Determine current capacity sigma for each cell included in battery module —S14

Determine capacity sigma change amount for
each cell included in battery module —S15

Detect abnormally deteriorated cell from battery module —S16

S17

No — Is there abnormally deteriorated cell?

Yes

Transmit information on abnormally deteriorated cell to upper controller —S18

# FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2021184278 A1